(19) Europäisches Patentamt
European Patent Office
Office européen des brevets

(11) EP 0 367 446 B1

# (12) EUROPEAN PATENT SPECIFICATION

(45) Date of publication and mention
of the grant of the patent:
**20.01.1999 Bulletin 1999/03**

(51) Int Cl.⁶: **H01L 29/861**, H01L 29/30

(21) Application number: **89310727.6**

(22) Date of filing: **18.10.1989**

(54) **Semiconductor commutator**

Halbleiterkommutator

Commutateur semi-conducteur

(84) Designated Contracting States:
**DE FR GB NL**

(30) Priority: **20.10.1988 JP 262930/88**

(43) Date of publication of application:
**09.05.1990 Bulletin 1990/19**

(73) Proprietor: **CANON KABUSHIKI KAISHA
Tokyo (JP)**

(72) Inventors:
• **Koizumi, Toru
Machida-shi Tokyo (JP)**
• **Mizutani, Hidemasa
Sagamihara-shi Kanagawa-ken (JP)**

(74) Representative:
**Beresford, Keith Denis Lewis et al
BERESFORD & Co.
2-5 Warwick Court
High Holborn
London WC1R 5DJ (GB)**

(56) References cited:
EP-A- 0 178 447            EP-A- 0 244 081
US-A- 3 900 943            US-A- 4 259 683
US-A- 4 646 427

• **PATENT ABSTRACTS OF JAPAN, vol. 9, no. 131
(E-319)[1854], 6th June 1985; & JP- A-60 16 466
(SUWA SEIKOSHA K.K.) 28-01-1985**

## Description

The present invention relates to a diode for use in a high speed switching commutator circuit. It also relates to a commutator circuit including such diode and a method of producing such a diode.

For commutator circuit applications diodes should have fast switching characteristics. Furthermore, for efficient operation such diodes should also exhibit low leakage current when reversed biased to the OFF state condition.

In a monocrystalline PN junction diode carrier lifetimes ordinarily are long. When the diode is switched from the ON state to the OFF state, excessive minority carriers remain and, as a consequence, the delay time for switching following bias voltage reversal is long. The switching speed in such diodes, accordingly, is unsatisfactory for high speed switching applications such as commutator circuit application.

Hitherto, in order to improve switching speed, a heavy metal, for example gold, has been introduced to act as a recombination centre to reduce minority carrier lifetime and thus decrease switching delay time.

A high switching speed PN junction diode using recombination centres to reduce minority carrier lifetime is disclosed in United States Patent US-A-4259683. The diode disclosed therein is of a type which comprises:

first and second semiconductor regions of opposite conductivity type adjoined at a PN junction; and a localised region of recombination centres, disposed in said first semiconductor region, and which is offset from the PN junction so that the recombination centres do not cross the PN junction. The diode of the present invention is a diode of this type.

The diode described in US-A-4259683, is such that the peak amount of carrier recombination occurs during device turnoff. The region of reduced carrier lifetime such as that provided by gold heavy metal recombination centres, causes fast carrier recombination during device turnoff such that the device switching speed is correspondingly increased over that of comparable conventional diodes.

However, where gold is used as a recombination centre, a problem arises in that electric field is concentrated in the vicinity of the gold centres, which therefore can lead to premature electric field breakdown and an increase in leakage current.

There is also known a PN diode comprising adjoining regions of opposite electroconductivity type of monocrystalline semiconductor material and polycrystalline semiconductor material, respectively. Although, in a diode of this construction, the lifetime of minority carriers in the polycrystalline material is relatively low, it is a problem that the PN junction interface between these materials is crossed by numerous grain boundaries. It is a problem that impurities tend to be segregated at these grain boundaries and lead thus to field concentration and increased leakage current.

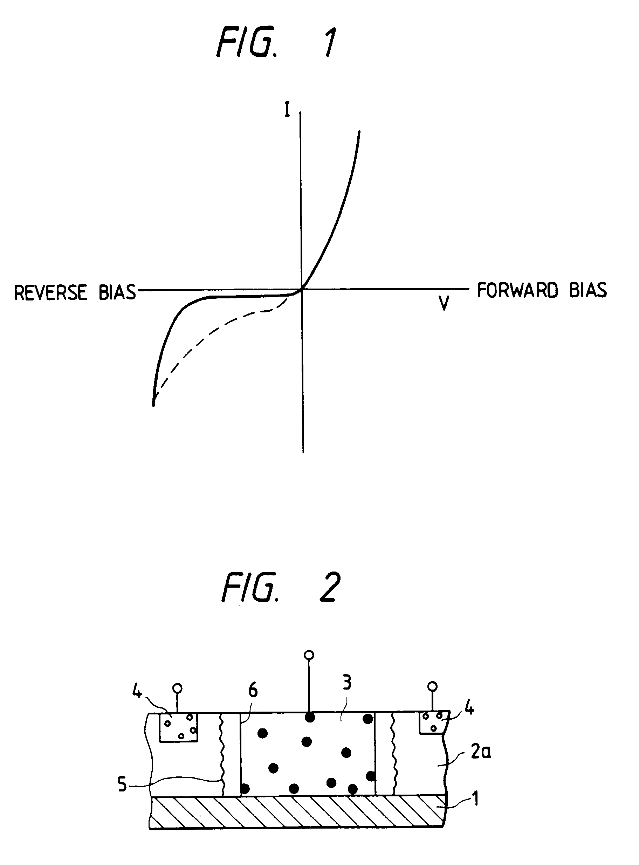

Figure 1 shows a typical current versus voltage characteristic of a PN junction diode. In the figure, the solid curve shows the ideal preferred characteristic. A typical characteristic, however, is shown by broken line. It can be seen from this characteristic that there is a substantial leakage current in the state of reverse bias.

For the above reason it has been considered undesirable to have polycrystalline material grain boundaries in the immediate vicinity of the diode PN junction. In Patent Abstracts of Japan, Vol. 9, No. 131, (E-319) [1854] June 6, 1985 and published Japanese Patent Application JP-A-60016466 there is described a method of producing a PN junction diode in which a region of polycrystalline silicon thin film is radiated by laser and a corresponding monocrystalline silicon region is grown from the resulting liquid phase. Subsequently, respective P and N type impurities are introduced to define a PN junction in the monocrystalline region. The size of the monocrystalline region is chosen such that the characteristics of the PN junction are determined by the monocrystalline material and thus unaffected by the polycrystalline material at the boundaries of this region which are remote from the PN junction. In this way a stable breakdown voltage and a low reverse bias current can be achieved. Such a diode, however, exhibits long minority carrier lifetime and is thus unsuitable for high speed switching applications.

In accordance with the present invention there is provided a diode for use in a high speed switching commutator circuit which is of the type discussed hereinabove with reference to US-A-4259683. The diode of the present invention, however, is characterised in that:

the first semiconductor region includes a grain boundary defining the localised region of the combination centres and is located to lie beyond the depletion region extending into the first semiconductor region within a minority carrier diffusion length from a depletion edge thereof when the diode is reverse biassed to the OFF state condition.

The grain boundary aforementioned is effective in reducing minority carrier lifetime and thus effective to reduce the time taken to switch off the diode. Furthermore, since the grain boundary is offset from the depletion region, the problem of increase in leakage current is avoided.

In order that the invention may be more readily understood, embodiments thereof will now be described by way of example and with reference to the accompanying drawings in which:

Fig. 1 is a graph showing the current to voltage characteristics of a PN junction diode;
Fig. 2 is a schematic partial cross sectional view for explaining a construction of a semiconductor commutator of an embodiment 1 of the invention;
Fig. 3 is a schematic partial plan view of the semiconductor commutator;

Fig. 4 is a schematic partial cross sectional view for explaining an arrangement of a grain boundary of the semiconductor commutator;

Figs. 5A to 5E are respectively schematic vertical sectional views showing manufacturing steps to form a crystal substrate which is used in the semiconductor commutator of the embodiment of the invention;

Fig. 6 is a schematic perspective view showing an $Si_3N_4$ film formed on an $SiO_2$ film;

Fig. 7 is a schematic partial plan view showing a construction of a semiconductor commutator of an embodiment 2 of the invention;

Fig. 8 is a schematic partial plan view showing a wiring state of the semiconductor commutator of the embodiment 2 of the invention; and

Fig. 9 is a circuit diagram showing a circuit which is used to measure a recovery time in the reverse direction of the semiconductor commutator of the embodiment of the invention.

DETAILED DESCRIPTION OF THE PREFERRED EMBODIMENTS

An embodiment of the invention will be described in detail hereinbelow with reference to the drawings.

First, manufacturing steps to form a crystal substrate having a grain boundary which is used in a semiconductor commutator of the embodiment of the invention will be described.

For instance, a crystal growing method disclosed in E.P. Application Publication No. 0,244,081 can be used.

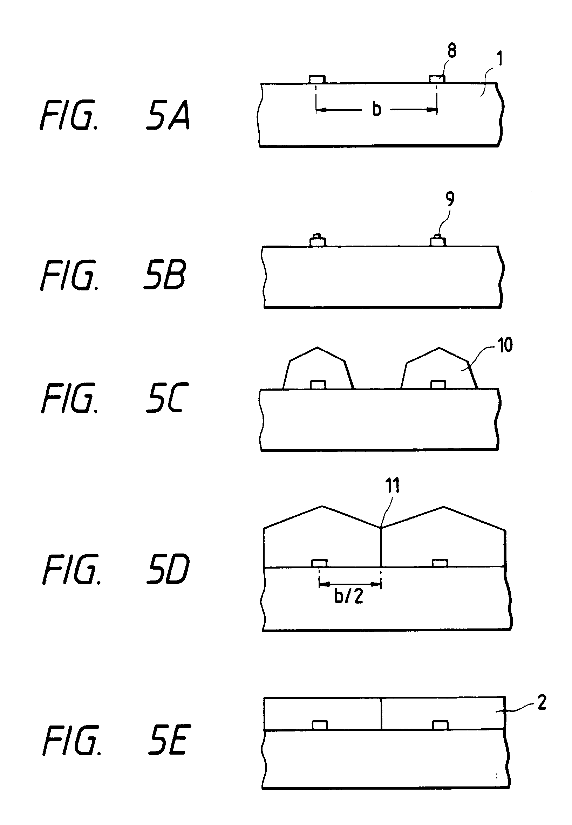

Figs. 5A to 5E are vertical sectional views showing an example of the manufacturing steps to form a crystal substrate which is used in the semiconductor commutator in the embodiment of the invention.

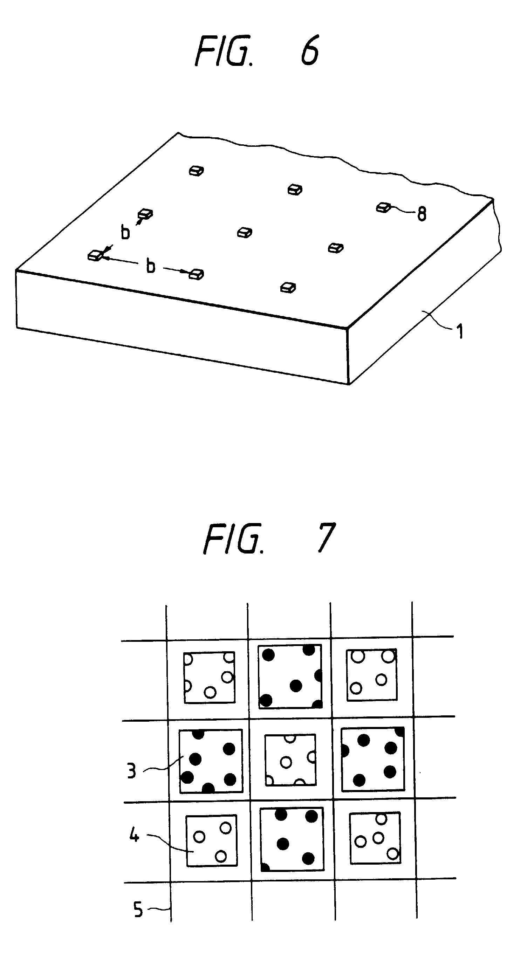

Fig. 6 is a perspective view showing an $Si_3N_4$ film formed on an $SiO_2$ film and corresponds to the manufacturing step shown in Fig. 5A.

First, as shown in Figs. 5A and 6, $SiO_2$ film 1 having a thickness of 2000 Å serving as a non-nucleus forming surface is formed on a silicon wafer of (100) by using a thermal oxidation process. An $Si_3N_4$ film of 300 Å is deposited onto the $SiO_2$ film 1. Further, the $Si_3N_4$ film is patterned by using a well-known fine processing technique in a manner such that nuclei each having a size of 2 $\mu m\square$ are arranged at at an interval b (in this case, b = 100 $\mu m$). A resultant $Si_3N_4$ film 8 serving as a nucleus forming surface which was formed is hereinafter called a site.

Next, as shown in Fig. 5B, by executing a vapor phase growing process of the $SiH_2C\ell_2/H_2/PH_3$ system, a crystal nucleus of Si can be formed only in the site 8 since the nucleus forming concentration of $Si_3N_4$ is larger than that of $SiO_2$. If the size of the site 8 is set to be sufficiently small, only one crystalline nucleus 9 of Si to be grown into single crystalline silicon can be formed in the single site 8.

Next, as shown in Fig. 5C, when crystal is subsequently grown, only one crystalline nucleus 9 on each site 8 continuously grows, an Si monocrystalline grain 10 is formed, and the Si monocrystalline grain 10 can be further grown.

Next, as shown in Fig. 5D, the Si monocrystalline grains 10 which grew from both of the adjacent sites 8 are joined at the center between the sites 8, thereby forming a grain boundary 11. As shown in the diagram, the grain boundary 11 is formed in the direction perpendicular to the substrate.

Then, as shown in Fig. 5E, the substrate on which the grain boundary 11 was formed by joining the Si monocrystalline grains 10 is ground until the thickness of the crystalline layer becomes 2 $\mu m$, thereby forming a monocrystalline layer 2. Thus, an n type silicon crystalline substrate in which the position of the grain boundary was controlled like a lattice of an interval of 100 $\mu m$ and a phosphorus (P) concentration is set to 1 x $10^{16}$ atom/cm$^3$ was obtained.

In the invention, the crystalline substrate in which the position of the grain boundary was controlled is a significant component member and, preferably, it can be formed by using the crystal growing method disclosed in the E.P. Application Publication No. 0,244,081 mentioned above. However, the invention is not limited to such a method but any other preferable methods can be also used, if a grain boundary position can be controlled by the methods.

The semiconductor commutator of the invention can be manufactured as follows by using the n type silicon crystalline substrate formed by the manufacturing steps described above.

(Embodiment 1)

Fig. 2 is a partial cross sectional view for explaining a construction of a semiconductor commutator of the embodiment 1 of the invention.

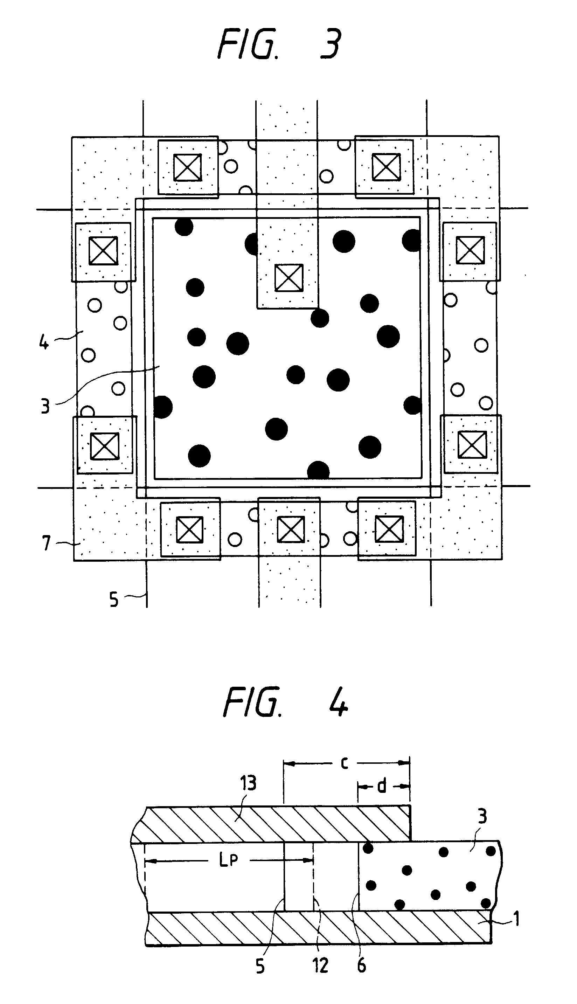

Fig. 3 is a partial plan view of the semiconductor commutator.

Fig. 4 is a partial cross sectional view for explaining an arrangement of a grain boundary of the semiconductor commutator.

First, on the n type silicon crystalline substrate, an $SiO_2$ film with a thickness of 5000 Å is formed. Next, in order to form high impurity concentration region within only a desired single crystal grain in the single crystal layer 2, a portion of the $SiO_2$ film corresponding to the single crystalline grain is removed. In the present embodiment, a 93 $\mu m$ square portion of $SiO_2$ was removed. Next, using $SiO_2$ film as a mask, BN diffusion is conducted at a temperature 100°C for 2 hours, thereby generating an impurity diffusion layer which extends through the layer (silicon wafer in the present embodiment). A high impurity p type semiconductor region 3 as shown in Fig. 2 is formed. The state of this is described with reference to Fig. 4 as follows.

In Fig. 4, reference numeral 13 denotes a BN diffused oxide film for masking. c indicates the distance from a grain boundary 5 to the edge portion of the $SiO_2$ film (in this case, about 3.5 µm) and d represents the distance of the diffusion in the lateral direction by the BN diffusion (in this case, about 1.4 µm and corresponds to about 70 % of the depth). The main surface on which the p type semiconductor region 3 and an n type semiconductor region 2a were ground and the grain boundary 5 are perpendicularly formed almost in parallel with a junction surface 6.

In order to form an $n^+$ type semiconductor region 4 which contacts the n type monocrystalline grain (n type semiconductor region 2a) adjacent to the monocrystalline grain in which the $p^+$ type semiconductor region 3 is formed, a thermal oxide film having a thickness of 4000 Å is formed. Thereafter, the $SiO_2$ film is selectively eliminated, a PSG film having a thickness of 4000 Å is deposited, a heat treatment is executed at 900°C for 30 minutes, and impurities (P) are diffused. As shown in Fig. 3, contact holes are formed and aluminum (Aℓ) is evaporation deposited and they are used as electrodes. An $SiO_2$ film having a thickness of 1000 Å is deposited as a protective film.

It should be noted here that, as shown in Fig. 4, the grain boundary 5 exists in a region which extends from a depletion edge 12 for a diffusion length $L_p$ ($L_p$ denotes a diffusion length of a hole). In the embodiment, the diffusion length $L_p$ is set to about up to 5 µm and the junction surface 6 exists at a position which is spaced from the grain boundary 5 by about 2 µm when considering also the diffusion distance d in the lateral direction due to the BN diffusion. On the other hand, since a depletion layer width is set to about 1 µm at 20 volts, as shown in Fig. 4, the grain boundary 5 is located within the diffusion length $L_p$ from the depletion edge 12.

In the embodiment, a number of excessive minority carriers exist in the region from the depletion edge 12 to the diffusion length $L_p$ and the recombination center existing in such a region most effectively functions. Therefore, even if the number of defects existing in this region is not so large, the switching operation can be executed at a high speed. That is, according to the invention, there is provided a semiconductor commutator which can operate at a high speed and has good current to voltage characteristics by effectively using a grain boundary defect, as a recombination center, in which a grain boundary is arranged between the junction surface and the electrode so as not to cross the junction surface.

It is considered that the defect level of the grain boundary defect exists at the center than 0.2 eV of gold, and the grain boundary defect functions as a more effective recombination center than gold. That is, a level which most effectively operates as the recombination center is ones at a midst of the bandgap. A level of gold is at 0.2 eV from the midst of two bandgap, while, since the defect level of the grain boundary is at the midst, the defect energy level effectively acts as the recombination center rather than that of the gold. Since its concentration lies within a range about from $10^{12}/cm^2$ to $10^{13}/cm^2$, it corresponds to $10^{17}/cm^3$ or more in the case where gold is used as a recombination center. Thus, the current density in the reverse direction is set to up to $10^{-8}$ Å and this value is not so different from that of the commutator formed on the monocrystalline substrate obtained by a Cz method.

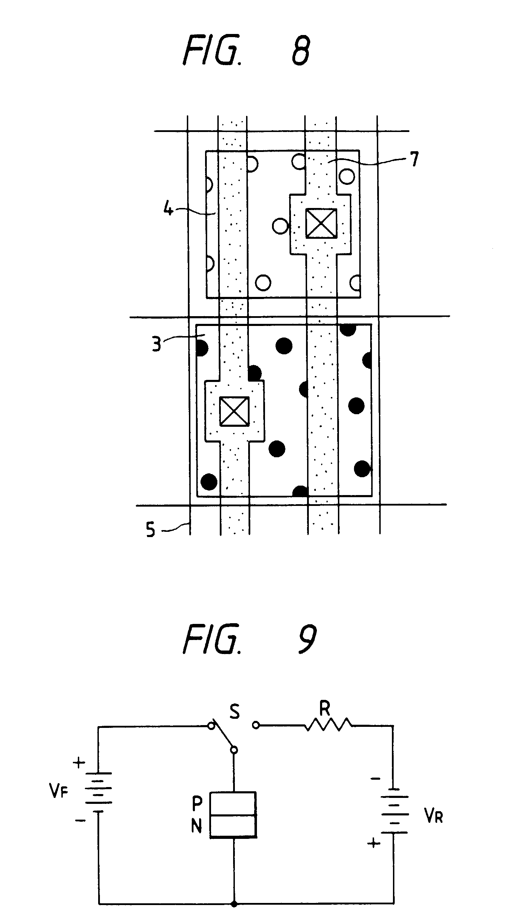

The semiconductor commutator of the embodiment exhibits the good I-V characteristics of the low dark current. An external circuit is set such that

$$\frac{I_F(V_F)}{V_R/R} \sim 100$$

by using a circuit shown in Fig. 9 and the recovery time in the reverse direction was measured. Thus, the high speed switching characteristics of up to 5 nsec were obtained.

(Embodiment 2)

This embodiment relates to the case where the semiconductor commutator in embodiment 1 mentioned above was two-dimensionally arranged.

Fig. 7 is a partial plan view showing a construction of a semiconductor commutator in the embodiment 2 of the invention.

Fig. 8 is a partial plan view showing a wiring state of the semiconductor commutator.

As shown in Fig. 7, in the embodiment, P type semiconductor regions and N type semiconductor regions are alternately arranged like a zigzag pattern with respect to the columns and rows. Fig. 7 shows a part of the arrangement of the matrix of 10 rows x 10 columns.

The semiconductor commutator of the embodiment can be also formed by using the crystal growing method disclosed in E.P. Application Publication No. 0,244,081 in a manner similar to the embodiment 1. The $SiCℓH_2/H_2/HCℓ$ system is used as a material gas system and the crystalline layer is grown until a single crystalline grain diameter becomes 50 µm. Thereafter, it is ground until the thickness of the monocrystalline layer becomes 2 µm.

Then, under the conditions similar to those in the embodiment 1, after a $P^+$ layer and an $N^+$ layer were formed, contact holes and Aℓ wirings are formed and an $SiO_2$ layer having a thickness of 10000 Å is further deposited as a protective film by a sputtering method.

In the embodiment 1, since a junction area larger than the area which is occupied by the device cannot be obtained, there will be a case that the embodiment 1 cannot cope with the situation where a relatively large current is needed. However, in the embodiment 2, by arranging the N and P type semiconductor regions like a zigzag pattern a current value which is two or more times as large as that in the embodiment 1 can be obtained by the same area. Therefore, by using such an arrangement, a semiconductor commutator having a large junction area can be also manufactured in a small space.

The semiconductor commutator obtained in the embodiment exhibits the good I/V characteristics as shown by a solid line in Fig. 1. An external circuit is set such that the switching speed becomes.

$$\frac{I_F(V_F)}{V_R/R} \sim 100$$

by using the circuit shown in Fig. 9. The recovery time in the reverse direction was measured. Thus, the high speed switching characteristics of up to 5 nsec were obtained.

As described in detail above, according to the semiconductor commutator of the invention, it is possible to realize the semiconductor commutator in which the good I-V characteristics are obtained and the recovery time in the reverse direction has a value on the order of nsec and which can operate at a high speed.

## Claims

1. A diode for use in a high-speed switching commutator circuit, said diode comprising:

    first and second semiconductor regions (2a, 3) of opposite conductivity type adjoined at a pn junction (6); and
    a localised region of recombination centres, which localised region is disposed in said first semiconductor region, and is offset from said pn junction (6) so as not to cross the same (6);

    which diode is characterised in that:
    said first semiconductor region includes a grain boundary (5) defining said localised region, located to lie beyond the depletion region extending into said first semiconductor region within a minority carrier diffusion length (4) from the depletion edge (12) when said diode is reverse biassed to OFF state condition.

2. A diode as claimed in claim 1 wherein:

    said first semiconductor region has a planar main surface; and
    said grain boundary (5) extends from said planar main surface in a perpendicular direction.

3. A diode as claimed in either preceding claim wherein said first semiconductor region comprises first and second monocrystalline grains adjoined at said grain boundary (5), and said second semiconductor region (3) is defined within said second monocrystalline grain.

4. A diode as claimed in any preceding claim wherein said first semiconductor region is of n conductivity type and said second semiconductor region is of p conductivity type.

5. A diode as claimed in claim 1 comprising a semiconductor layer (2) defining said first semiconductor region (2a);

    a plurality of grain boundaries (5) defining a lattice network dividing said semiconductor layer (2) into a plurality of grains; and
    a plurality of separate second semiconductor regions (3), formed in said semiconductor layer (2), each formed at a respective lattice position in a respective one of said grains without crossing said grain boundaries (5), each of opposite conductivity type to the surrounding first semiconductor region (2a), and of relatively higher dopant concentration than said first semiconductor region (2a), with respective pn junctions (6) between said first semiconductor region (2a) and said second semiconductor regions (3) being arranged thus in a zig-zag pattern in diagonal directions of said lattice network.

6. Use of a diode, claimed in any preceding claim, in a commutator circuit.

7. A commutator circuit including a diode claimed in any of claims 1 to 5, connected to respective sources of forward and reverse bias via a switch.

8. A method of producing the diode of claim 1 including:

    producing a planar semiconductor layer having first and second grains adjoined at a vertical grain boundary (5);
    diffusing a first type dopant impurity into said semiconductor layer;
    masking said semiconductor layer by a mask (13) overlapping said grain boundary (5), and a part of said second grain adjacent to said grain boundary (5), the edge of said mask (13) being offset from said grain boundary (5) by a first predetermined distance (c);
    diffusing a second type dopant minority, opposite in type to said first type, into said second grain, to form a pn junction (6) beneath said mask (13) at a second predetermined distance (d) from the edge of said mask (13), such that said grain boundary (5) shall be offset from said pn junction (6) so as not to cross the same (6) and located to lie beyond the depletion region extending into said first semiconductor region within a minority carrier diffusion length (4) from the depletion edge (12) when said diode is reverse biassed to OFF state condition.

9. A method as claimed in claim 8 wherein said planar semiconductor layer is produced by defining nucleation sites (8) on the surface of a substrate (1), producing a single nucleus (9) of the semiconductor material on both sites (8), epitaxially growing semiconductor material from each nucleus until two grains (10) are grown which meet at a grain boundary (11; 5), and flattening and thinning said grains by grinding.

**Patentansprüche**

1. Diode zur Verwendung in einer Hochgeschwindigkeits-Schaltkommutator-Schaltung, wobei die Diode

an einem pn-Übergang (6) angrenzende erste und zweite Halbleiterbereiche (2a, 3) entgegengesetzter Leitfähigkeit und einen Punktbereich von Rekombintionszentren aufweist, wobei der Punktbereich in dem ersten Halbleiterbereich angeordnet und von dem pn-Übergang (6) versetzt ist, um diesen (6) nicht zu kreuzen,

**dadurch gekennzeichnet, daß**

der erste Halbleiterbereich eine den Punktbereich definierende Korngrenze (5) aufweist, die jenseits des sich in den ersten Halbleiterbereich erstreckenden Verarmungsbereichs und innerhalb einer Minoritätsladungsträger-Diffusionslänge (4) von dem Verarmungsrand (12) liegt, wenn die Diode für eine AUS-Zustandsbedingung in Sperrichtung vorgespannt ist.

2. Diode nach Anspruch 1,
**dadurch gekennzeichnet, daß**

der erste Halbleiterbereich eine ebene Hauptoberfläche aufweist und die Korngrenze (5) sich von der ebenen Hauptoberfläche in senkrechter Richtung erstreckt.

3. Diode nach einem der vorangehenden Ansprüche, **dadurch gekennzeichnet, daß**
der erste Halbleiterbereich an der Korngrenze (5) angrenzende erste und zweite monokristalline Körner aufweist, wobei der zweite Halbleiterbereich (3) innerhalb des zweiten monokristallinen Korns definiert ist.

4. Diode nach einem der vorangehenden Ansprüche, **dadurch gekennzeichnet, daß**
der erste Halbleiterbereich eine n-Leitfähigkeit und der zweite Halbleiterbereich eine p-Leitfähigkeit aufweisen.

5. Diode nach Anspruch 1,
**gekennzeichnet durch**

eine den ersten Halbleiterbereich (2a) definierende Halbleiterschicht (2), eine Vielzahl von Korngrenzen (5), die ein die Halbleiterschicht (2) in eine Vielzahl von Körnern aufteilendes Gitternetz definieren, und eine Vielzahl von in der Halbleiterschicht (2) ausgebildeten getrennten zweiten Halbleiterbereichen (3), die jeweils an einer jeweiligen Gitterposition in einem jeweiligen der Körner ohne Kreuzen der Korngrenzen (5), jeweils mit zu dem umgebenden ersten Halbleiterbereich (2a) entgegengesetzter Leitfähigkeit und mit einer relativ höheren Dotierstoffkonzentration als der erste Halbleiterbereich (2a) ausgebildet sind, wobei jeweilige pn-Übergänge (6) zwischen dem ersten Halbleiterbereich (2a) und den zweiten Halbleiterbereichen (3) somit in einem Zickzack-Muster in diagonalen Richtungen des Gitternetzs angeordnet sind.

6. Verwendung einer Diode nach einem der vorangehenden Ansprüche in einer Kommutatorschaltung.

7. Kommutatorschaltung mit einer Diode nach einem der Ansprüche 1 bis 5,
die über einen Schalter an jeweilige Spannungsquellen zur Vorspannung in Durchlaßrichtung und in Sperrichtung angeschlossen ist.

8. Verfahren zur Herstellung der Diode nach Anspruch 1,

mit den Schritten
Herstellen einer ebenen Halbleiterschicht mit an einer vertikalen Korngrenze (5) angrenzenden ersten und zweiten Körnern, Diffundieren einer Störstelle ersten Dotierstofftyps in die Halbleiterschicht, Maskieren der Halbleiterschicht durch eine die Korngrenze (5) und einen Teil des an die Korngrenze (5) angrezenden zweiten Korns überlagernde Maske (13), wobei der Rand der Maske (13) um einen ersten vorbestimmten Abstand (c) von der Korngrenze (5) versetzt ist, Diffundieren eines Minoritätsdotierstoffs zweiten zu dem ersten Typ entgegengesetzten Typs in das zweite Korn zur Ausbildung eines pn-Übergangs (6) unterhalb der Maske (13) an einem zweiten vorbestimmten Abstand (d) von dem Rand der Maske (13) derart, daß die Korngrenze (5) von dem pn-Übergang (6) versetzt ist, um diesen (6) nicht zu kreuzen, und jenseits des sich in den ersten Halbleiterbereich erstreckenden Verarmungsbereichs und innerhalb einer Minoritätsladungsträger-Diffusionslänge (4) von dem Verarmungsrand (12) liegt, wenn die Diode für eine AUS-Zustandsbedingung in Sperrichtung vorgespannt ist.

9. Verfahren nach Anspruch 8, wobei
die ebene Halbleiterschicht durch Definieren von Kernbildungsorten (8) auf der Oberfläche eines Substrats (1), Herstellen eines einzelnen Kerns (9) des Halbleitermaterials an beiden Orten (8), Halbleitermaterial-Epitaxie von jedem Kern bis an einer Korngrenze (11; 5) sich treffende zwei Körner (10) gewachsen sind, und Abflachen und Verdünnen der Körner durch Schleifen hergestellt wird.

## Revendications

1. Diode pour utilisation dans un circuit de commutation à commutation rapide, ladite diode comprenant :

des première et seconde régions semi-conductrices (2a, 3) de type à conductivité opposée, contiguës au niveau d'une jonction pn (6) ; et une région localisée de centres de recombinaison, laquelle région localisée est disposée dans ladite première région semi-conductrice, et est décalée de ladite jonction pn (6) de façon à ne pas la croiser ;

laquelle diode se caractérise en ce que :
ladite première région semi-conductrice comprend une limite de grain (5) définissant ladite région localisée, située pour se trouver au-delà de la région de déplétion s'étendant dans ladite première région semi-conductrice à l'intérieur d'une longueur (4) de diffusion de porteurs minoritaires depuis le bord de déplétion (12) lorsque ladite diode est polarisée en sens inverse dans l'état hors circuit (OFF).

2. Diode selon la revendication 1, dans laquelle :

ladite première région semi-conductrice présente une surface principale plane ; et ladite limite de grain (5) s'étend depuis ladite surface principale plane dans une direction perpendiculaire.

3. Diode selon l'une quelconque des revendications précédentes, dans laquelle ladite première région semi-conductrice comprend des premier et second grains monocristallins contigus au niveau de ladite limite de grain (5), et dans laquelle ladite seconde région semi-conductrice (3) est définie à l'intérieur dudit second grain monocristallin.

4. Diode selon l'une quelconque des revendications précédentes, dans laquelle ladite première région semi-conductrice a une conductivité de type n et ladite seconde région semi-conductrice a une conductivité de type p.

5. Diode selon la revendication 1, comprenant une couche semi-conductrice (2) définissant ladite première région semi-conductrice (2a) ;

plusieurs limites de grain (5) définissant un réseau en treillis divisant ladite couche semi-conductrice (2) en plusieurs grains ; et plusieurs secondes régions semi-conductrices distinctes (3), formées dans ladite couche semi-conductrice (2), chacune étant formée à une position de treillis respective dans l'un respectif desdits grains sans croiser lesdites limites de grain (5), chacune étant de type à conductivité opposée à celle de la première région semi-conductrice périphérique (2a), et ayant une concentration de dopants relativement plus forte que celle de ladite première région semi-conductrice (2a), les jonctions pn respectives (6) entre ladite première région semi-conductrice (2a) et ladite seconde région semi-conductrice (3) étant donc agencées en un motif en zigzag dans des directions diagonales audit réseau en treillis.

6. Utilisation d'une diode, telle que revendiquée selon l'une quelconque des revendications précédentes, dans un circuit de commutation.

7. Circuit de commutation comprenant une diode, telle que revendiquée selon l'une quelconque des revendications 1 à 5, connectée, par l'intermédiaire d'un commutateur, à des sources respectives de polarisation en sens direct et en sens inverse.

8. Procédé de fabrication de la diode selon la revendication 1, comprenant le fait :

de produire une couche semi-conductrice plane comportant des premier et second grains contigus au niveau d'une limite de grain verticale (5) ;
de diffuser un premier type d'impureté de dopage dans ladite couche semi-conductrice ;
de masquer ladite couche semi-conductrice par un masque (13) recouvrant ladite limite de grain (5) et une partie dudit second grain contiguë à ladite limite de grain (5), le bord dudit masque (13) étant décalé de ladite limite de grain (5) d'une première distance (c) prédéterminée ;

de diffuser une seconde minorité de type de dopant, de type opposé audit premier type, dans ledit second grain, pour former une jonction pn (6) au-dessous dudit masque (13) à une seconde distance (d) prédéterminée du bord dudit masque (13), de façon que ladite limite de grain (5) soit décalée de ladite jonction pn (6) de façon à ne pas la croiser et soit située pour se trouver au-delà de la région de déplétion s'étendant dans ladite première région semi-conductrice à l'intérieur d'une longueur de diffusion de porteurs minoritaires (4) depuis le bord de déplétion (12) lorsque ladite diode est polarisée en sens inverse à l'état hors circuit (OFF).

9. Procédé selon la revendication 8, dans lequel ladite couche semi-conductrice plane est produite en définissant des sites de nucléation (8) sur la surface d'un substrat (1), en produisant un seul noyau (9) de la matière semi-conductrice sur l'un et l'autre des sites (8), en faisant croître, de façon épitaxiale, la matière semi-conductrice à partir de chaque noyau jusqu'à ce que deux grains (10) se soient développés, lesquels se rencontrent au niveau d'une limite de grain (11 ; 5) et en aplanissant et en amincissant lesdits grains par meulage.

FIG. 1

FIG. 2

FIG. 3

FIG. 4

FIG.  5A

FIG.  5B

FIG.  5C

FIG.  5D

FIG.  5E

# FIG. 6

# FIG. 7

# FIG. 8

# FIG. 9